# DEMANDE DE BREVET EUROPEEN

(11) **EP 4 016 200 A1**
(43) Date de publication de la demande: **22.06.2022**
(21) Numéro de dépôt: 20216139.4
(22) Date de dépôt: 21.12.2020
(51) Int. Cl.: G04G 9/00, G02F 1/1333

(54) **PROCÉDÉ DE FABRICATION D'UN DISPOSITIF D'AFFICHAGE DIGITAL ET DISPOSITIF D'AFFICHAGE DIGITAL**

(71) Demandeur: The Swatch Group Research and Development Ltd, 2074 Marin (CH)
(72) Inventeur: SAGARDOYBURU, Michel, 2000 Neuchâtel (CH); SPRINGER, Simon, 3007 Berne (CH)
(74) Mandataire: ICB SA

(57) **Abrégé**

La présente invention concerne un procédé de fabrication d'un dispositif d'affichage digital qui comprend un milieu optiquement actif disposé entre au moins une électrode (10) et une contre-électrode (14) correspondante, les propriétés optiques du milieu optiquement actif étant modifiables par application d'un courant ou d'une tension électrique entre la au moins une électrode (10) et la au moins une contre-électrode (14) correspondante, le dispositif d'affichage digital comprenant une surface d'affichage transparente (34) à travers laquelle au moins une information affichée par ce dispositif d'affichage digital est perceptible, le procédé de fabrication comprenant l'étape qui consiste à munir la surface d'affichage transparente (34) du dispositif d'affichage digital d'au moins un premier et un second motif (36, 38) décoratif et/ou fonctionnel, le premier motif (36) ayant une épaisseur différente de celle du second motif (38).

L'invention concerne également un dispositif d'affichage digital muni d'au moins un premier et un second motifs décoratifs et/ou fonctionnels dont les épaisseurs ne sont pas les mêmes.

## Description

### Domaine technique de l'invention

La présente invention concerne un procédé de fabrication d'un dispositif d'affichage digital de même qu'un dispositif d'affichage digital. La présente invention concerne en particulier un procédé de fabrication permettant de munir un dispositif d'affichage digital d'un motif décoratif et/ou fonctionnel.

### Arrière-plan technologique

La présente invention s'intéresse aux dispositifs d'affichage de type digital, c'est-à-dire les dispositifs d'affichage qui sont capables d'afficher des informations sous forme alphanumérique, par opposition aux dispositifs d'affichage analogiques qui affichent les informations au moyen d'une ou de plusieurs aiguilles qui se déplacent en regard de graduations.

Une famille bien connue de dispositifs d'affichage digitaux regroupe les dispositifs d'affichage à cristaux liquides. Ces dispositifs d'affichage à cristaux liquides comprennent classiquement un substrat avant transparent situé du côté d'un observateur, et un substrat arrière, transparent ou non, qui s'étend parallèlement et à distance du substrat avant. Ces deux substrats avant et arrière sont habituellement réunis entre eux au moyen d'un cadre de scellement qui délimite une enceinte étanche dans laquelle une composition de cristal liquide est confinée. Enfin, les substrats avant et arrière sont revêtus sur leurs faces en regard d'électrodes et de contre-électrodes transparentes électriquement conductrices ; par application d'un champ électrique entre une électrode et une contre-électrode correspondante, on modifie les propriétés optiques de la composition de cristal liquide au point de croisement de l'électrode et de la contre-électrode considérées.

Une autre famille bien connue de dispositifs d'affichage digitaux regroupe les cellules d'affichage à diodes organiques électroluminescentes également connues sous leur dénomination anglo-saxonne Organic Light Emitting Diodes ou OLED. Il s'agit de composants monolithiques à semiconducteurs qui comprennent classiquement une série de films minces organiques prise en sandwich entre deux électrodes en film mince conductrices de l'électricité. Lorsqu'un courant électrique est appliqué à un composant OLED, il se crée entre les deux électrodes un champ électrique sous l'effet duquel les porteurs de charges, électrons et trous, migrent depuis les électrodes dans les films minces organiques jusqu'à ce qu'ils se recombinent dans une zone émissive en formant des excitons, c'est-à-dire des paires électron-trou liées par les forces de Coulomb. Une fois formés, ces excitons, ou états excités, se relaxent vers un niveau d'énergie moindre en émettant des photons (électroluminescence) et de la chaleur, produisant ainsi un signal lumineux perceptible par l'œil humain à travers celle des électrodes qui est agencée sur la face de sortie du composant OLED.

Plus généralement, la présente invention s'intéresse donc à des dispositifs d'affichage digitaux qui comprennent un milieu optiquement actif disposé entre au moins une électrode et une contre-électrode correspondante, les propriétés optiques du milieu optiquement actif étant modifiables par application d'un courant ou d'une tension entre la au moins une électrode et la au moins une contre-électrode correspondante.

Les dispositifs d'affichage digitaux du genre brièvement décrit ci-dessus équipent notamment de nombreux objets portables tels que des montres-bracelets, offrant ainsi une alternative aux montres-bracelets munies d'un cadran au-dessus duquel se déplacent des aiguilles.

Parmi les avantages que procurent les dispositifs d'affichage digitaux, on peut citer leur légèreté, leur très faible consommation électrique ou bien encore la possibilité d'afficher des informations sous forme alphanumérique, ce qui plaît à une partie importante des consommateurs, notamment parmi les plus jeunes d'entre eux.

Les dispositifs d'affichage digitaux, en particulier les dispositifs d'affichage à cristaux liquides, présentent cependant également certains inconvénients au premier rang desquels on peut citer leur aspect ennuyeux et répétitif. Avec les dispositifs d'affichage à cristaux liquides, on est en effet très éloigné des combinaisons d'aspects, de couleurs, de matières, de formes et autres qu'offrent les cadrans de montres-bracelets à aiguilles. En effet, les dispositifs d'affichage digitaux présentent tous plus ou moins le même aspect et il est difficile d'impartir à une montre-bracelet équipée par exemple d'un dispositif d'affichage à cristal liquide un aspect qui va permettre de la distinguer distinctement d'une montre-bracelet à dispositif d'affichage à cristal liquide de la concurrence.

### Résumé de l'invention

La présente invention a pour but de remédier aux problèmes mentionnés ci-dessus ainsi qu'à d'autres encore en procurant un procédé de fabrication d'un dispositif d'affichage à cristaux liquides qui permet d'impartir à un tel dispositif d'affichage un aspect plus original lui permettant de se distinguer des dispositifs d'affichage à cristaux liquides de la concurrence.

A cet effet, la présente invention concerne un procédé de fabrication d'un dispositif d'affichage digital qui comprend un milieu optiquement actif disposé entre au moins une électrode et une contre-électrode correspondante, les propriétés optiques du milieu optiquement actif étant modifiables par application d'un courant ou d'une tension électrique entre la au moins une électrode et la au moins une contre-électrode correspondante, le dispositif d'affichage digital comprenant une face inférieure et une face supérieure à travers laquelle au moins une information affichée par ce dispositif d'affichage digital est perceptible, le procédé de fabrication comprenant l'étape qui consiste à munir la face supérieure du dispositif d'affichage digital d'au moins un premier et un second motif décoratif et/ou fonctionnel, le premier motif ayant une épaisseur différente de celle du second motif.

Grâce à ces caractéristiques, la présente invention procure un procédé de fabrication permettant d'obtenir un dispositif d'affichage digital dont la face à travers laquelle l'information élaborée et affichée par ce dispositif d'affichage digital est perceptible est munie d'au moins un premier et un second motif dont les épaisseurs sont différentes. Ces motifs d'épaisseurs différentes forment à la surface du dispositif d'affichage digital des reliefs qui, par le jeu des ombres et des reflets de la lumière ambiante sur les arêtes des motifs, donnent du volume à la face du dispositif d'affichage digital sur laquelle ils sont prévus. Cette impression de volume est encore renforcée par le fait qu'étant donné que les motifs n'ont pas la même épaisseur, cela donne un sentiment de profondeur variable lorsqu'on examine la face du dispositif d'affichage digital qui est munie de ces motifs. Ainsi, selon que l'on regarde la zone où se trouve le premier motif ou la zone où se trouve le second motif, l'observateur a l'impression que les informations affichées dans l'une ou l'autre des deux zones ne se trouvent pas à la même profondeur par rapport à la surface d'affichage transparente du dispositif d'affichage digital.

Selon une forme particulière d'exécution de l'invention, le au moins un premier et le au moins un second motif sont directement formés sur la surface d'affichage transparente du dispositif d'affichage digital par application et structuration d'une ou de plusieurs couches d'au moins une résine photosensible.

Selon une autre forme particulière d'exécution de l'invention, la ou les couches d'au moins une résine photosensible sont structurées par photolithographie.

Selon encore une autre forme d'exécution de l'invention, le au moins un premier et le au moins un second motif sont directement formés sur la surface d'affichage transparente du dispositif d'affichage digital par :
- dépôt d'une couche de résine photo-polymérisable ;
- réplication du au moins un premier et du au moins un second motif dans la couche de résine photo-polymérisable au moyen d'un moule ;
- durcissement de la couche de résine photo-polymérisable par exposition à un rayonnement lumineux, et
- élimination de la résine qui n'a pas été exposée au rayonnement lumineux.

Selon encore une autre forme d'exécution de l'invention, la résine photo-polymérisable est exposée à un rayonnement ultraviolet.

Selon encore une autre forme d'exécution de l'invention, le au moins un premier et le au moins un second motif sont fabriqués dans une plaque transparente en relief, puis la plaque transparente est fixée sur la surface d'affichage du dispositif d'affichage digital.

Selon encore une autre forme d'exécution de l'invention, la plaque transparente en relief est réalisée au moyen de l'une des techniques suivantes :
- par injection d'un matériau plastique ;
- par dépôt sur la plaque transparente d'une couche de résine photo-polymérisable, puis réplication du au moins un premier et du au moins un second motif dans la couche de résine photo-polymérisable au moyen d'un moule, puis durcissement de la couche de résine photo-polymérisable par exposition à un rayonnement lumineux, et enfin élimination de la résine qui n'a pas été exposée au rayonnement lumineux ;
- par emboutissage à chaud de la plaque transparente, ou bien
- par moulage de la plaque transparente au moyen d'une colle bi-composant dans un moule.

Selon encore une autre forme d'exécution de l'invention, l'épaisseur des motifs est comprise entre 1 µm et 1 mm.

Selon encore une autre forme d'exécution de l'invention, le dispositif d'affichage digital est une cellule d'affichage à cristaux liquides ou une cellule d'affichage à diodes organiques électroluminescentes.

L'invention concerne également une pièce d'horlogerie comprenant un dispositif d'affichage digital obtenu par mise en oeuvre du procédé selon l'invention.

### Brève description des figures

D'autres caractéristiques et avantages de la présente invention ressortiront plus clairement de la description détaillée qui suit d'un mode de mise en oeuvre du procédé selon l'invention, cet exemple étant donné à titre purement illustratif et non limitatif seulement en liaison avec le dessin annexé sur lequel :
- la figure 1 est une vue en coupe d'une cellule d'affichage à cristaux liquides sur la surface d'affichage transparente de laquelle ont été reportés un premier et un second motif d'épaisseurs différentes ;
- les figures 2A à 2D illustrent les étapes d'un procédé de fabrication des premier et second motifs par réplication au moyen d'un moule dans une couche de résine photosensible ;
- la figure 3 est une vue en élévation et en coupe de la cellule d'affichage à cristaux liquides de la figure 1 sur la surface d'affichage de laquelle est fixée une plaque transparente dans laquelle sont formés les premier et second motifs, et
- la figure 4 est une vue de dessus d'une montre-bracelet équipée d'une cellule d'affichage à cristaux liquides obtenue par mise en œuvre du procédé selon l'invention.

### Description détaillée de l'invention

La présente invention procède de l'idée générale inventive qui consiste à munir la surface d'affichage transparente d'un dispositif d'affichage digital tel qu'une cellule d'affichage à cristaux liquides ou bien une cellule d'affichage à diodes organiques d'au moins un premier et un second motif décoratif et/ou fonctionnel qui se distinguent l'un de l'autre par leurs épaisseurs qui ne sont pas les mêmes. Du fait de leur différence de hauteur, ces premier et second motifs donnent du relief à la surface d'affichage transparente à travers laquelle les informations élaborées et affichées par la cellule d'affichage digital sont perceptibles. En effet, en se réfléchissant sur le bord des premier et second motifs, la lumière change plusieurs fois de direction, ce qui met en évidence les différences de hauteurs entre les premier et second motifs et donne l'impression que les informations affichées par la cellule d'affichage digital se trouvent dans des plans différents, conférant ainsi à la surface d'affichage transparente un aspect plus luxueux et plus travaillé.

La présente invention va être plus particulièrement décrite en liaison avec un dispositif d'affichage digital du type d'une cellule d'affichage à cristaux liquides. On comprendra néanmoins que la présente invention n'est pas limitée à cet exemple particulier et qu'elle s'applique à tout type de dispositif d'affichage digital muni d'une surface d'affichage transparente à travers laquelle les informations élaborées par ce dispositif d'affichage digital sont perceptibles. On pense en particulier aux cellules d'affichage à diodes organiques électroluminescentes.

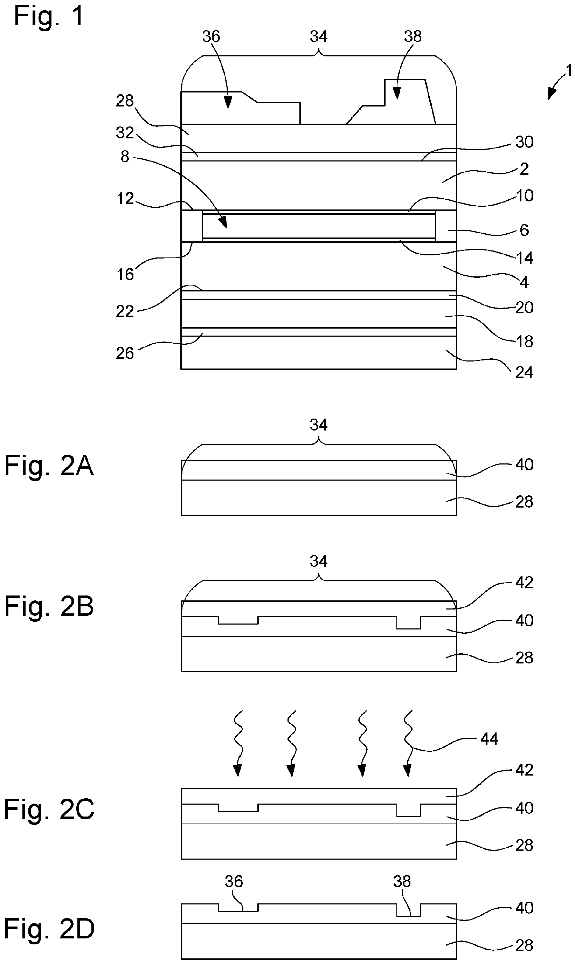

Désignée dans son ensemble par la référence numérique générale 1, la cellule d'affichage à cristaux liquides représentée en élévation et en coupe à la figure 1 comprend un substrat avant 2 et un substrat arrière 4 qui s'étend parallèlement à et à distance du substrat avant 2. Le substrat avant 2 à travers lequel les informations élaborées et affichées par la cellule d'affichage à cristaux liquides 1 sont perceptibles est transparent, tandis que le substrat arrière 4 peut être également transparent ou opaque. Dans l'exemple illustré à la figure 1, le substrat arrière 4 est transparent et les substrats avant 2 et arrière 4 sont réalisés en une matière plastique ou en verre.

Les substrats avant 2 et arrière 4 sont conventionnellement réunis entre eux par un cadre de scellement 6 qui délimite une enceinte étanche 8 pour le confinement d'une composition de cristal liquide. Au moins une électrode 10 est structurée sur une face inférieure 12 du substrat avant 2 et au moins une contre-électrode 14 correspondante est structurée sur une face supérieure 16 du substrat arrière 4. Par application d'un champ électrique entre la au moins une électrode 10 et la au moins une contre-électrode 14, on modifie les propriétés optiques de la composition de cristal liquide au point de croisement des électrodes considérées. Un polariseur réflectif transparent 18 est fixé, par exemple au moyen d'une couche d'adhésif transparent 20, sur une face inférieure 22 du substrat arrière, et un film noir 24 est fixé, par exemple au moyen d'une autre couche d'adhésif transparent 26, sur le polariseur réflectif transparent 18. Enfin, un polariseur absorbant transparent 28 est fixé sur la face supérieure 30 du substrat avant 2, par exemple au moyen d'encore une autre couche d'adhésif transparent 32.

Le substrat avant 2 revêtu du polariseur absorbant transparent 28 forme la surface d'affichage transparente 34 par laquelle les informations élaborées par la cellule d'affichage à cristaux liquides 1 sont perceptibles par l'observateur. Conformément à l'invention, on munit la surface d'affichage transparente 34 de la cellule d'affichage à cristaux liquides 1 d'au moins un premier et un second motif 36, respectivement 38, décoratif et/ou fonctionnel, le premier motif 36 ayant une épaisseur différente de celle du second motif 38. L'épaisseur des premier et second motifs 36, 38 est préférentiellement comprise entre 1 µm et 1 mm.

Selon une première forme d'exécution de l'invention, les premier et second motifs 36, 38 sont directement formés sur la surface d'affichage transparente 34 de la cellule à d'affichage cristaux liquides 1 par application et structuration d'une ou de plusieurs couches d'au moins une résine photosensible. La ou les couches de résine photosensible sont structurées par photolithographie. On structure par exemple une première couche de résine d'une première épaisseur pour former le premier motif 36, puis on structure une seconde couche de résine d'une seconde épaisseur différente de la première épaisseur pour former le second motif 38.

Selon une deuxième forme d'exécution de l'invention illustrée aux figures 2A et suivantes, les premier et second motifs 36, 38 sont directement formés sur la surface d'affichage transparente 34 de la cellule d'affichage à cristaux liquides 1 par :
- dépôt d'une couche de résine photo-polymérisable 40 (figure 2A) ;
- réplication des premier et second motifs 36, 38 dans la couche de résine photo-polymérisable 40 au moyen d'un moule 42 (figure 2B) ;
- durcissement de la couche de résine photo-polymérisable 40 par exposition à un rayonnement lumineux 44 à travers le moule 42 (figure 2C), et
- retrait du moule 42 (figure 2D).

A titre d'exemple préféré mais non limitatif, la résine photo-polymérisable est exposée à un rayonnement lumineux 44 ultraviolet.

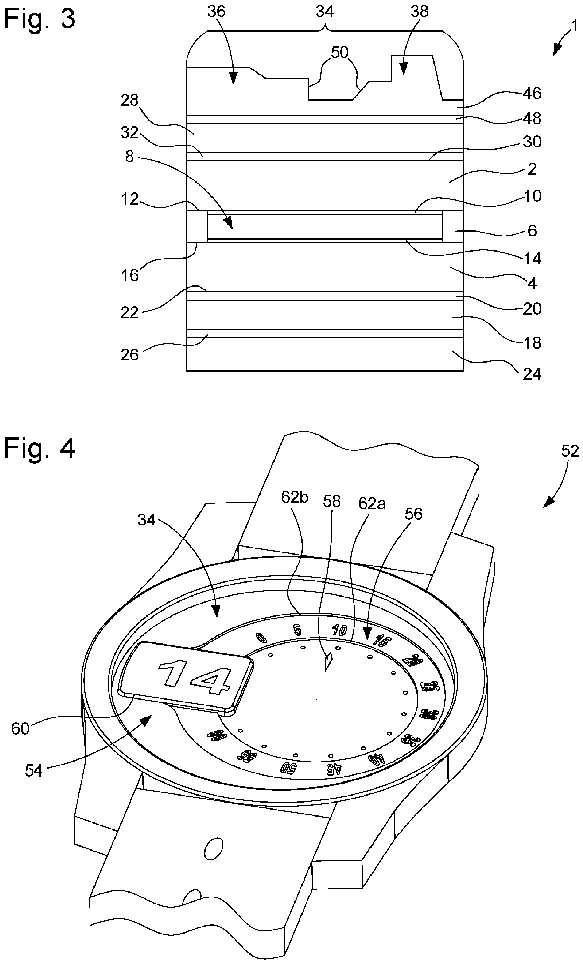

Selon une troisième forme d'exécution de l'invention illustrée à la figure 3, au lieu de former les premier et second motifs 36, 38 directement sur la surface d'affichage transparente 34 de la cellule d'affichage à cristaux liquides 1, il est également possible de fabriquer les premier et second motifs 36, 38 dans une plaque transparente 46 en relief, puis de fixer cette plaque transparente 46 sur la surface d'affichage transparente 34 par exemple au moyen d'une couche de colle 48 optiquement transparente.

La plaque transparente 46 munie de ses premier et second motifs 36, 38 en relief peut être obtenue au moyen de l'une des techniques suivantes :
- par injection d'une matière plastique dans un moule ;
- par emboutissage à chaud d'une plaque transparente de départ ;
- par moulage au moyen d'une colle bi-composant dans un moule. ;
- par dépôt, sur une plaque transparente de base, d'une couche de résine photo-polymérisable, puis par réplication des premier et second motifs en relief dans la couche de résine photo-polymérisable au moyen d'un moule, puis par durcissement de la couche de résine photo-polymérisable par exposition à un rayonnement lumineux à travers le moule, et enfin retrait du moule.

On obtient ainsi une cellule d'affichage à cristaux liquides 1 dont la surface d'affichage transparente 34 reçoit, soit directement, soit par l'intermédiaire d'une plaque transparente 46, des premier et second motifs 36, 38 d'épaisseurs différentes. Par suite, lorsque la lumière se réfléchit sur les tranches 50 de ces premier et second motifs 36, 38, elle change plusieurs fois de direction, ce qui met en évidence les différences de hauteurs entre les premier et second motifs 36, 38 et donne une impression de profondeur et un aspect plus luxueux et plus travaillé à la surface d'affichage transparente 34 de la cellule d'affichage à cristaux liquides 1.

Un exemple d'une montre-bracelet 52 équipée d'une cellule d'affichage à cristaux liquides 1 selon l'invention est illustré à la figure 4. Comme visible à l'examen de cette figure 4, la surface d'affichage transparente 34 de la cellule d'affichage à cristaux liquides 1 présente une première zone d'affichage 54 de forme rectangulaire qui fournit une indication de l'heure courante par exemple sur une base 24 heures. En l'occurrence, la première zone d'affichage 54 indique à l'observateur qu'il est 14 heures. La surface d'affichage transparente 34 est également munie d'une seconde zone d'affichage 56 en forme d'anneau qui indique les minutes de l'heure courante à l'aide d'une graduation qui s'échelonne de 5 minutes en 5 minutes. En l'occurrence, dans l'exemple représenté à la figure 4, un repère mobile 58 pointe sur l'indication « 10 minutes». On comprend donc que l'heure indiquée par la montre-bracelet 52 est 14h10. Selon l'invention, la première zone d'affichage 54 est entourée sur tout son périmètre d'une première bordure 60, et la seconde zone d'affichage 56 est entourée sur toute sa circonférence d'une bordure intérieure 62a et d'une bordure extérieure 62b concentriques l'une par rapport à l'autre. Selon l'invention, la première bordure 60 est plus épaisse, autrement dit plus haute, que les bordures intérieure 62a et extérieure 62b. Par le jeu des réflexions multiples de la lumière sur la tranche des bordures 62a, 62b, on obtient un effet de profondeur pour les zones d'affichage 54 et 56, avec le sentiment que la seconde zone d'affichage 56 est à un niveau plus bas que la première zone d'affichage 54.

Il va de soi que la présente invention n'est pas limitée au mode de mise en œuvre qui vient d'être décrit, et que diverses modifications et variantes simples de l'invention peuvent être envisagées sans sortir du cadre de l'invention tel que défini par les revendications annexées. En particulier, on comprendra que bien que l'invention ait été décrite en liaison avec une cellule d'affichage à cristaux liquides, il va de soi que l'invention n'est pas limitée à ce seul exemple et qu'elle s'applique à d'autres types de dispositifs d'affichage digitaux tels que, notamment, une cellule d'affichage à diodes organiques électroluminescentes sur la surface d'affichage transparente de laquelle peuvent aussi être reportés au moins un premier et un second motif dont les épaisseurs sont différentes. On comprend de même que, bien que dans l'exemple décrit, les premier et second motifs sont structurés sur un polariseur absorbant transparent fixé sur la face supérieure du substrat avant d'une cellule d'affichage à cristal liquide, cet exemple est donné à titre purement illustratif et non limitatif, ces motifs pouvant être structurés par exemple sur une plaque transparente qui est ensuite fixée sur le polariseur. On comprendra également que pour que l'effet optique lié à la réflexion de la lumière ambiante se produise et procure la sensation de profondeur recherchée, il faut au moins deux motifs d'épaisseurs différentes, le nombre de ces motifs pouvant néanmoins être bien supérieur à 2. On comprendra aussi qu'il faut veiller à ce que les motifs soient convenablement alignés par rapport aux zones d'affichage du dispositif d'affichage digital. Les motifs peuvent également être réalisés sous formes de structures en relief répétitives pour imiter des finitions de cadrans que l'on rencontre dans le domaine de l'horlogerie tels que des cadrans brossés, des finitions clous de Paris ou brossé-soleil et autres. Ces motifs sont réalisés par application et structuration d'une ou de plusieurs couches d'au moins une résine photosensible. Il est aussi intéressant de donner à la surface supérieure des motifs un fini poli afin d'augmenter les réflexions de la lumière ambiante sur ces motifs et ainsi donner davantage encore de volume à la surface d'affichage transparente du dispositif d'affichage digital en mettant en avant certaines zones de la surface d'affichage transparente par rapport à d'autres. On comprendra aussi que la surface d'affichage transparente sera d'autant plus réfléchissante que son indice de réfraction optique est élevé. Il est également possible de combiner les motifs avec des traitements antireflets de la surface d'affichage transparente ou de la plaque transparente. Ces traitements antireflets sont par exemple du type « motheye » ou « antiglare » et sont obtenus par structuration nanométrique, respectivement micrométrique, de la surface d'affichage transparente ou de la plaque transparente. Une autre technique disponible pour fabriquer les motifs est l'impression par jet d'encre encore appelée Digital Printing en terminologie anglo-saxonne. Suivant les épaisseurs des motifs recherchées, on dépose une ou plusieurs couches d'encre que l'on laisse sécher à l'air libre, ou bien que l'on fait sécher au four. L'encre déposée peut également être de type photo-polymérisable.

### Nomenclature

1. Cellule d'affichage à cristaux liquides
2. Substrat avant
4. Substrat arrière
6. Cadre de scellement
8. Enceinte étanche
10. Electrode
12. Face inférieure
14. Contre-électrode
16. Face supérieure
18. Polariseur réflectif transparent
20. Couche d'adhésif transparent
22. Face inférieure
24. Film noir
26. Couche d'adhésif transparent
28. Polariseur absorbant transparent
30. Face supérieure
32. Couche d'adhésif transparent
34. Surface d'affichage transparente
36. Premier motif
38. Second motif
40. Couche de résine photo-polymérisable
42. Moule
44. Rayonnement lumineux
46. Plaque transparente
48. Couche de colle
50. Tranches
52. Montre-bracelet
54. Première zone d'affichage
56. Seconde zone d'affichage
58. Repère mobile
60. Première bordure
62a. Bordure intérieure
62b. Bordure extérieure

## Revendications

1. Procédé de fabrication d'un dispositif d'affichage digital qui comprend un milieu optiquement actif disposé entre au moins une électrode (10) et une contre-électrode (14) correspondante, les propriétés optiques du milieu optiquement actif étant modifiables par application d'un courant ou d'une tension électrique entre la au moins une électrode (10) et la au moins une contre-électrode (14) correspondante, le dispositif d'affichage digital comprenant une surface d'affichage transparente (34) à travers laquelle au moins une information affichée par ce dispositif d'affichage digital est perceptible, le procédé de fabrication comprenant l'étape qui consiste à munir la surface d'affichage transparente (34) du dispositif d'affichage digital d'au moins un premier et un second motif décoratif et/ou fonctionnel (36, 38), le premier motif (36) ayant une épaisseur différente de celle du second motif (38).

2. Procédé de fabrication selon la revendication 1, **caractérisé en ce que** les au moins un premier et second motifs (36, 38) sont directement formés sur la surface d'affichage transparente (34) du dispositif d'affichage digital par application et structuration d'une ou de plusieurs couches d'au moins une résine photosensible ou bien par impression à jet d'encre.

3. Procédé de fabrication selon la revendication 2, **caractérisé en ce que** la ou les couches d'au moins une résine photosensible sont structurées par photolithographie.

4. Procédé de fabrication selon la revendication 2, **caractérisé en ce que** les au moins un premier et un second motifs (36, 38) sont directement formés sur la surface d'affichage transparente (34) du dispositif d'affichage digital par :
- dépôt d'au moins une couche de résine photo-polymérisable (40) ;
- réplication des au moins un premier et second motifs (36, 38) dans la couche de résine photo-polymérisable (40) au moyen d'un moule (42) ;
- durcissement de la couche de résine photo-polymérisable (40) par exposition à un rayonnement lumineux (44) à travers le moule (42), et
- retrait du moule (42).

5. Procédé de fabrication selon l'une des revendications 2 à 4, **caractérisé en ce que** la couche de résine photo-polymérisable (40) est exposée à un rayonnement ultraviolet.

6. Procédé de fabrication selon la revendication 1, **caractérisé en ce qu'**il comprend l'étape qui consiste à fabriquer les au moins un premier et second motifs (36, 38) dans une plaque transparente (46) en relief, puis à fixer la plaque transparente (46) sur la surface d'affichage transparente (34) du dispositif d'affichage digital au moyen d'une couche de colle (48) optiquement transparente.

7. Procédé de fabrication selon la revendication 6, **caractérisé en ce que** la plaque transparente (46) en relief est réalisée au moyen de l'une des techniques suivantes :
- par injection d'une matière plastique ;
- par dépôt sur une plaque transparente de départ d'une couche de résine photo-polymérisable, puis par réplication du au moins un premier et du au moins un second motif dans la couche de résine photo-polymérisable au moyen d'un moule, puis par durcissement de la couche de résine photo-polymérisable par exposition à un rayonnement lumineux à travers le moule, et enfin retrait du moule ;
- par emboutissage à chaud d'une plaque transparente de départ ;
- par moulage de la plaque transparente au moyen d'une colle bi-composant dans un moule, ou bien
- par impression à jet d'encre.

8. Procédé de fabrication selon l'une quelconque des revendications 1 à 7, **caractérisé en ce que** l'épaisseur des au moins un premier et second motifs (36, 38) est comprise entre 1 µm et 1 mm.

9. Procédé de fabrication selon l'une des revendications 1 à 8, **caractérisé en ce que** le dispositif d'affichage digital est une cellule d'affichage à cristaux liquides (1) ou une cellule d'affichage à diodes organiques électroluminescentes.

10. Procédé de fabrication selon l'une des revendications 1 à 9, **caractérisé en ce que** les au moins un premier et second motifs (36, 38) sont réalisés sous formes de structures en relief répétitives pour imiter des finitions de type cadrans brossés, brossé-soleil, clous de Paris, bouchonnage et tissage.

11. Procédé de fabrication selon l'une des revendications 1 à 10, **caractérisé en ce que** l'on donne à la surface supérieure des au moins un premier et second motifs (36, 38) un fini poli.

12. Procédé de fabrication selon l'une quelconque des revendications 1 à 11, **caractérisé en ce que** l'on combine les au moins un premier et second motifs (36, 38) avec un traitement antireflet de la surface d'affichage transparente (34) ou de la plaque transparente (46).

13. Procédé de fabrication selon la revendication 12, **caractérisé en ce que** le traitement antireflet est obtenu par structuration nanométrique ou micrométrique de la surface d'affichage transparente (34) ou de la plaque transparente (46).

14. Pièce d'horlogerie comprenant un dispositif d'affichage digital obtenu par mise en œuvre du procédé selon l'une des revendications précédentes.

15. Dispositif d'affichage digital comprenant un milieu optiquement actif disposé entre au moins une électrode (10) et une contre-électrode (14) correspondante, les propriétés optiques du milieu optiquement actif étant modifiables par application d'un courant ou d'une tension électrique entre la au moins une électrode (10) et la au moins une contre-électrode (14) correspondante, le dispositif d'affichage digital comprenant une surface d'affichage transparente (34) à travers laquelle au moins une information affichée par ce dispositif d'affichage digital est perceptible, cette surface d'affichage transparente (34) étant revêtue d'au moins un premier et un second motif (36, 38) décoratif et/ou fonctionnel, le premier motif (36) ayant une épaisseur différente de celle du second motif (38).
